# EUROPEAN PATENT SPECIFICATION

(11) **EP 0 576 078 B1**
(45) Date of publication and mention of the grant of the patent: **26.05.1999**
(21) Application number: 93201750.2
(22) Date of filing: 18.06.1993
(51) Int. Cl.: H04B 1/26, H03D 7/16

(54) **FM receiver**
FM-Empfänger
Récepteur FM

(30) Priority: 26.06.1992 EP 92201908
(43) Date of publication of application: 29.12.1993
(73) Proprietor: Koninklijke Philips Electronics N.V., 5621 BA Eindhoven (NL)
(72) Inventor: Bijker, Wolter, NL-5656 AA Eindhoven (NL); Kasperkovitz, Wolfdietrich, NL-5656 AA Eindhoven (NL); de Ruyter, Hendricus Clemens, NL-5656 AA Eindhoven (NL); Sloof, Willem Arie, NL-5656 AA Eindhoven (NL)
(74) Representative: Groenendaal, Antonius Wilhelmus Maria

(56) References cited:
- DE-A- 4 020 805
- US-A- 4 262 361
- US-A- 4 653 117

## Description

The invention relates to an FM receiver comprising an RF section, a first mixer stage for converting a desired RF reception signal to a first IF signal having a carrier frequency located on average at a first intermediate frequency, a first IF section for selecting the first IF signal, a second mixer stage for converting the first IF signal to a second IF signal having a carrier frequency located on average at a second intermediate frequency, said second intermediate frequency being located below the first intermediate frequency, a second IF section for selecting the second IF signal, a third mixer stage for converting the second IF signal to a third IF signal having a carrier frequency located on average at a third intermediate frequency, said third intermediate frequency being located above the second intermediate frequency.

An FM receiver of this type is known from the United States Patent 4,262, 361. In this known FM receiver a variable bandwidth filtering and frequency converting system is used, which enables the bandwidth about the frequency to which the receiver is tuned to be varied in a continuous and stepless manner without affecting that frequency. This filtering and converting system comprises first, second and third mixers.
A variable frequency oscillator supplies an injection signal which is applied directly to the third mixer. The same injection signal, the frequency of which is doubled first in a frequency doubler, is applied to the second mixer.

It is an object of the invention to provide a substantially fully integrable IF stage which can be exchanged in a simple manner with the IF circuit of substantially all existing FM receivers of the superheterodyne type and realises a selectivity which may be considerably larger than that of the known IF filters.

According to the invention, an FM receiver of the type described in the opening paragraph is therefore characterized in that the third intermediate frequency is equal to the first intermediate frequency and mutually equal second and third mixing signals are applied to the second and third mixer stages, and in that the FM receiver further comprises an FM demodulator for demodulating the baseband modulation signal of said desired RF reception signal, and a low-pass filter coupled to an output of the FM demodulator for selecting the baseband modulation signal, an input of said FM demodulator being coupled via the third mixer stage to the second IF section.

This provides the possibility of generating the mixing signals of the second and third mixer stages by means of one and the same fixed local oscillator, which leads to a simplification of the FM receiver.

Moreover, in such an FM receiver the second mixer stage, the second IF section and the third mixer stage can be incorporated in and/or implemented as a detachable IF stage which is easily integrable as a component and is exchangeable with an IF filter tuned to said first intermediate frequency of a conventional superheterodyne FM receiver. When such an IF stage is used according to the invention as an IF selectivity in a conventional superheterodyne FM receiver, the last-mentioned preferred embodiment of an FM receiver according to the invention is obtained.

The FM receiver according to the invention provides the possibility of choosing the second intermediate frequency to be sufficiently low to realise a largely integrated form of the second IF section at a sufficiently large dynamic range and of choosing the third intermediate frequency to be sufficiently high to cause the higher order interference components occurring during the frequency demodulation to occur sufficiently far from the desired baseband modulation signal so that a suppression of these higher order interference components is possible by means of an easily integrable low-pass filter.

In this way, a good selectivity can be combined with a sufficiently large dynamic range and a considerably reduction of the higher order interference effect during the frequency demodulation, while a large degree of integration is possible.

According to the invention, an IF stage comprising a second mixer stage for converting a first IF signal having a carrier frequency located on average at a first intermediate frequency to a second IF signal having a carrier frequency located on average at a second intermediate frequency, said second intermediate frequency being located below the first intermediate frequency, a second IF section for selecting the second IF signal, a third mixer stage for converting the second IF signal to a third IF signal having a carrier frequency located on average at a third intermediate frequency, said third intermediate frequency being located above the second intermediate frequency, and which can be used in an FM receiver of the type described in the opening paragraph is therefore characterized in that the IF stage further comprises an IF input terminal to which the first IF signal can be supplied and an IF output terminal from which the third IF signal can be tapped, and in that the third intermediate frequency is equal to the first intermediate frequency and mutually equal second and third mixing signals are applied to the second and third mixer stages.

Another preferred embodiment of the FM receiver and particularly the IF stage according to the invention, in which a reduction of non-linear distortion is obtained with respect to the known FM receiver, is characterized by a phase-splitting device for converting a single-phase signal into a pair of phase-quadrature signals and a resonance amplifier operating as a tunable phase-quadrature IF selectivity, which resonance amplifier applies in-phase and quadrature components of the second IF signal from in-phase and quadrature outputs to said third mixer stage, said third mixer stage comprising in-phase and quadrature multiplier circuits as well as a superposition stage for converting the in-phase and quadrature components of the second IF signal to in-phase and quadrature components of the third IF signal and for mutually superpositioning the two last-mentioned in-phase and quadrature components for converting the third intermediate frequency signal from phase quadrature to single phase.

When this measure is used, the property is utilized that the resonance amplifier in said use as a phase-quadrature filter has a symmetrical bandpass characteristic and a point-symmetrical phase characteristic around the resonance frequency, even at a very low value of the resonance frequency. Such a resonance amplifier is fully integrable and known *per se,* for example from European Patent Application EP 0 420 974.

The resonance amplifier may also be used as a phase-splitting device by commonly applying the output signal of the second mixer stage to the in-phase and quadrature inputs of the resonance amplifier. At a sufficiently high quality factor Q of the resonance amplifier, there will be an accurate phase-quadrature relationship between the in-phase and quadrature output signals of the resonance amplifier.

It is alternatively possible to operate the second mixer stage as a phase-splitting device and to provide it to this end with in-phase and quadrature multiplier circuits, signal inputs of which are coupled in common to an output of the first IF section whose mixing signal inputs are coupled to in-phase and quadrature outputs of a fixed local phase-quadrature oscillator and signal outputs of which are coupled to in-phase and quadrature inputs of the resonance amplifier, said in-phase and quadrature outputs of the fixed local phase-quadrature oscillator being also coupled to respective mixing signal inputs of the in-phase and quadrature multiplier circuits of the third mixer stage.

To enhance the selectivity, the last-mentioned FM receiver according to the invention is preferably characterized in that the second IF section comprises a tunable IF selectivity having a tuning control input to which the baseband modulation signal of said desired RF reception signal is applied for a dynamic frequency tracking of the tuning of the tunable IF selectivity by means of the modulation signal.

An IF stage according to the invention, which when used as an IF selectivity in a conventional superheterodyne FM receiver results in the last-mentioned preferred embodiment of an FM receiver according to the invention and in which instabilities in the tuning control are prevented, is characterized in that the second IF section comprises a tunable IF selectivity having a tuning control input, said tunable IF selectivity preceding a FM demodulator which is arranged in a tuning control loop from the output of the tunable IF selectivity to the tuning control input, said tuning control loop having an open loop gain which is smaller than one.

A further elaboration of the above-mentioned aspect of the invention is realised in a further preferred embodiment of the last-mentioned FM receiver which is characterized in that the further FM demodulator comprises a limiter circuit which is connected *via* a fourth mixer stage to a first input and via a filter circuit, succeeded by a fifth mixer stage, to a second input of a multiplier circuit, mutually equal mixing signals being applied to said fourth and fifth mixer stages for an up-conversion of the frequency of the two input signals of the multiplier circuit. When this measure is used, the higher-order interference components produced during the demodulation are shifted further in frequency with respect to the desired baseband modulation signal so that the integration of the FM demodulator is simplified, while a simple low-pass filter at the output of the FM demodulator is sufficient to realise an effective suppression of interference.

Another preferred embodiment of the invention, in which the same effect with respect to the limiter and the FM demodulator is obtained, is characterized in that the further FM demodulator comprises a limiter circuit which is connected to a first input and, *via* a filter circuit, to a second input of a multiplier circuit, and a sixth mixer stage preceding the limiter circuit for an up-conversion of the frequency of the signal applied to the limiter.

Yet another preferred embodiment of the invention, in which filtering is possible at a comparatively low frequency, is characterized in that at least one of the first-mentioned and further FM demodulators comprises a limiter circuit, a multiplier circuit having two inputs and an output and a filter circuit arranged between the further limiter circuit and one of the two inputs of the multiplier circuit, said filter circuit being arranged between a seventh and an eighth mixer stage for a down-conversion and an up-conversion, respectively, of the frequency of the input signal and the output signal of the filter circuit.

These and other aspects of the invention will be apparent from and elucidated with reference to the embodiments described hereinafter. Corresponding elements are denoted by the same reference indications. In the drawings:
Fig. 1 shows a first embodiment of an FM receiver according to the invention;
Fig. 2 shows a second mixer stage operating as a phase-splitting device for use in an FM receiver according to the invention;
Fig. 3 shows a first embodiment of an FM demodulator for use in an FM receiver according to the invention;
Fig. 4 shows a second embodiment of an FM demodulator for use in an FM receiver according to the invention.

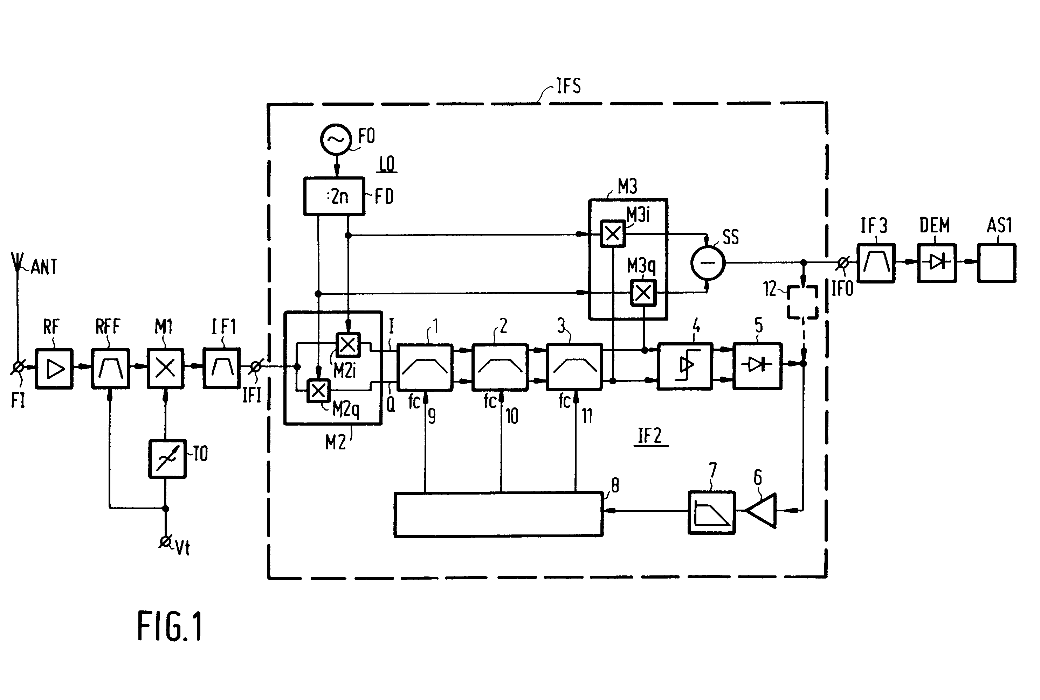

Fig. 1 shows an FM receiver according to the invention, having a radio frequency (RF) antenna input for connecting an antenna ANT thereto to which are successively coupled an RF input section RF and a tunable RF input filter RFF for RF amplification and selection of a desired RE FM reception signal, a first mixer stage M1 to which a tunable oscillation signal is applied from a tuning oscillator TO for a frequency conversion of the desired RF FM reception signal to a first intermediate frequency (IF) signal having a carrier frequency located on average at a first intermediate frequency f1, a first IF section IF1 for a first IF selection, a second IF stage IFS to be described hereinafter for a second IF selection, a third IF section IF3 for a third IF selection, a first FM demodulator DEM for demodulating the third IF signal selected by the third IF section IF3, a low-pass filter and audio signal processor ASP preceding a sound reproducing device L for a low-pass selection of the demodulated baseband modulation signal of said desired RF FM reception signal and for audio signal processing and reproduction, respectively.

A common tuning voltage is applied from a tuning control terminal Vt to tuning control inputs of the RFF and the tuning oscillator TO. Consequently, a tuning synchronism is obtained between the signal tuning on the one hand and the RFF on the other hand so that the RFF can be chosen to have a comparatively narrow band and hence an effective mirror suppression is obtained.

Except for the signal processing in the second IF stage IFS, the signal processing in the FM receiver described so far corresponds to that of a conventional superheterodyne FM receiver. For example, the first mixer stage M1 can realise a frequency conversion of an RF FM reception signal at an RF carrier frequency of the order of 100 MHz to a first intermediate frequency f1 of, for example 10.7 MHz. In contrast to the IF signal processing in such conventional superheterodyne FM receivers, the first IF signal of the first IF section IF1 of the FM receiver according to the invention is applied *via* an input terminal IFI of the second IF stage IFS to a second mixer stage M2 arranged in the second IF stage IFS. The second mixer stage M2 realises a frequency conversion of the first IF signal to a second IF signal having a carrier frequency located on average at a second intermediate frequency f2.

The second intermediate frequency f2 can be chosen to be relatively low with respect to the first intermediate frequency f1 so that it will be possible to achieve a high selectivity at a sufficiently large dynamic range with a comparatively simple bandpass filter circuit as the second IF selectivity. A further improvement of the selectivity will be possible by giving such a bandpass filter circuit a tunable structure and by varying the tuning with the demodulated baseband modulation signal. To this end for example, an output of the first FM demodulator DEM may be coupled (not shown) to a tuning control input of said bandpass filter circuit. To obtain a sufficient stability in the tuning control, the open loop gain of the tuning control loop which is coupled from the output of said bandpass filter circuit *via* the first FM demodulator DEM to the tuning control input of this bandpass filter circuit should be smaller than one. The tuning of the bandpass filter circuit thereby dynamically tracks the instantaneous frequency modulation of the second IF signal so that the bandwidth of the bandpass filter can be chosen to be considerably smaller than the bandwidth of the second IF signal.

In the embodiment shown a cascade circuit of three tunable resonance amplifiers 1-3 operating as bandpass filters has been chosen, which realise a tunable second IF selectivity of the second IF section IF2, each at a resonance frequency which tracks the instantaneous frequency modulation of the second IF signal and which is on average equal to the second intermediate frequency f2. To this end the output of said cascade circuit is fed back to tuning control inputs 9, 10 and 11 of the respective resonance amplifiers 1-3 *via* a limiter 4, a further, or second FM demodulator 5, a loop amplifier 6, a loop filter 7 and a tuning control signal generating circuit 8. The tuning control signal generating circuit 8 has three outputs which are coupled to tuning control inputs 9-11, respectively, of the resonance amplifiers 1-3. First, second and third tuning control loops are thereby formed. The open loop gain of each one of the first, second and third tuning control loops should be smaller than one so as to prevent instabilities in the loops. The elements 1-11 constitute a second IF section IF2 of the second IF stage IFS. The resonance amplifiers 1-3 can be easily integrated and render a very high selectivity possible. They are known *per se* from European Patent Application EU 0 420 974 and do not need to be further described for understanding the invention. In order to render a low-distortion selection possible at the comparatively low value of f2, the resonance amplifiers 1-3 are used as polyphase filters of the phase-quadrature type. To this end a phase-splitting device for converting a single-phase signal into a pair of phase-quadrature signals is to be arranged in the IF signal path.

In the embodiment of Fig. 1 a phase splitting is effected by way of example with the aid of the second mixer stage M2 which comprises in-phase and quadrature multiplier circuits M2i and M2q to which the first IF signal is applied from the first IF section IF1 jointly with in-phase and quadrature mixing signals from a local oscillator device LO. The local oscillator device LO comprises a fixed oscillator FO for supplying a fixed oscillator frequency flo, followed by a frequency division circuit FD. The frequency division circuit FD derives the last-mentioned in-phase and quadrature mixing signals from the oscillator frequency flo by dividing it by a division factor of 2n. Starting from the afore-mentioned numerical example with fl = 10.7 MHz, the second intermediate frequency f2 will be 300 kHz at an flo of, for example 22 MHz and a frequency division by two (n = 1) in the frequency division circuit FD and hence in-phase and quadrature mixing signals at 1/2 flo = 11 MHz.

The second mixer stage M2 does not only realise a down-conversion but also operates as a phase-splitting device in which in-phase and quadrature components I and Q of the second IF signal are obtained at f2 from the single-phase first intermediate frequency signal. As mentioned hereinbefore, this second phase-quadrature IF signal is filtered at a relatively high selectivity in the cascade circuit of the resonance amplifiers 1-3. Subsequently, the in-phase and quadrature components I and Q of the second IF signal are limited in amplitude in the limiter 4, followed by a demodulation in the second FM demodulator 5. This second FM demodulator 5 may be constructed in known manner and comprise, for example a multiplier circuit (not shown) with a frequency-dependent phase shifter which is operative for one of the in-phase and quadrature components I and Q of the second IF signal. The baseband modulation signal is applied to the tuning control signal generating circuit 8 from the output of the second FM demodulator 5 *via* the loop amplifier 6 and the loop filter 7, which tuning control signal generating circuit 8 may have, for example a junction point (not shown) *via* which the baseband modulation signal amplified in the loop amplifier 6 (possibly at a gain factor smaller than one) is applied in common to the tuning control inputs 9-11, or it may have a cascade arrangement of two amplifier circuits (not shown), which cascade arrangement has an input coupled to the tuning control terminal 9 and an output coupled to the tuning control terminal 11, the common junction point of the two amplifier circuits being connected to the tuning control terminal 10. The gain factors of these amplifier circuits are to be chosen in such a way that no instabilities are produced in the tuning control of the resonance amplifiers 1-3. This is achieved when the open loop gain of the tuning control loop of each one of these resonance amplifiers 1-3 is smaller than one. The tuning control does not require any further explanation for understanding the invention.

The output of the cascade circuit 1-3 is also coupled to an in-phase multiplier circuit M3i and a quadrature multiplier circuit M3q of a third mixer stage M3. The in-phase and quadrature mixing signals of the local oscillator device LO at flo are also applied to the in-phase multiplier circuit M3i and quadrature multiplier circuit M3q. The in-phase multiplier circuit M3i and quadrature multiplier circuit M3q of the third mixer stage M3 consequently supply in-phase and quadrature components of a third IF signal at a carrier frequency which is located on average at a third intermediate frequency f3 which is above the second intermediate frequency f2 and is equal to the first intermediate frequency f1 due to the common use of the local oscillator device LO. Outputs of the in-phase multiplier circuit M3i and the quadrature multiplier circuit M3q are coupled to inputs of a superposition stage SS which realises such a superposition of the mixing products obtained in the in-phase multiplier circuit M3i and quadrature multiplier circuit M3q that the mixing products occurring at f3 are mutually added to each other and the unwanted mixing products which are mirrored with respect to flo compensate each other. The third IF signal thus obtained will become available at an output terminal IFO of the second IF stage IFS.

The third IF signal with f3 = f1 is applied *via* the output terminal IFO of the second IF stage IFS to, successively, the third IF section IF3, the first FM demodulator DEM, the low-pass filter and the audio signal processor ASP and the sound reproducing device L in which, as mentioned hereinbefore, a third IF selection, a demodulation, a low-pass filtering, an audio signal processing and reproduction, respectively, take place in known manner.

The input and output signals of the second IF stage IFS at IFI and IFO are at one and the same intermediate frequency, at 10.7 MHz in the given case. The second IF stage IFS can therefore be easily implemented as a component in existing conventional superheterodyne FM receivers, resulting in an FM receiver according to the invention having a comparatively high IF selectivity. Moreover, due to the use of resonance amplifiers as phase-quadrature filters, the second intermediate frequency f2 can be chosen to be considerably lower than the second intermediate frequency of 700 kHz of the first-mentioned known FM receiver. In a practical embodiment of the FM receiver according to the invention the second intermediate frequency f2 was 300 kHz. Due to this low second intermediate frequency f2 the requirement with respect to the quality factor Q of the second IF stage IFS, which determines the dynamic range, is further decreased, which further simplifies the integration of this second IF stage IFS. Since the second IF stage IFS supplies a third IF signal which is relatively high in frequency to the FM demodulator DEM, the interference components produced during the demodulation are comparatively far remote from the baseband modulation signal and can be effectively suppressed by means of an easily integrable low-pass filter.

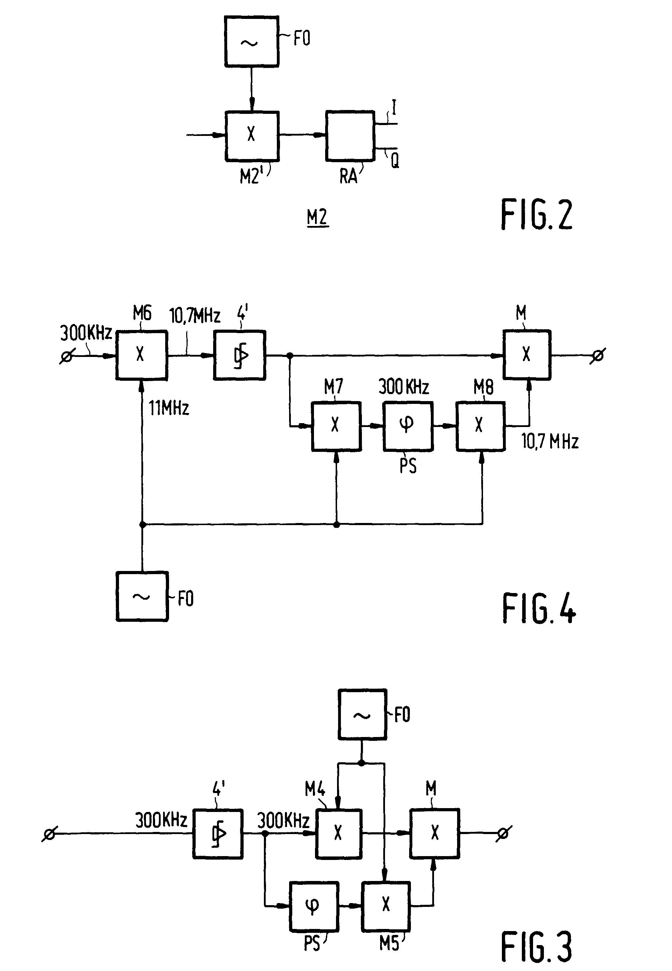

Another manner of down-conversion and phase splitting is shown in Fig. 2. In this Figure a frequency conversion is effected in a multiplier M2' and a conversion from single phase to phase quadrature is effected in a resonance amplifier RA coupled to an output of the multiplier M2'. A fixed local oscillator frequency of 11 MHz in the given case is applied from the fixed oscillator FO to the multiplier M2'. The resonance amplifier RA supplies in-phase and quadrature components of the second IF signal at the second intermediate frequency f2 from in-phase and quadrature outputs.

An alternative manner of tuning control is obtained by omitting the limiter 4 and the second FM demodulator and by using instead a third FM demodulator 12 which is shown in broken lines. The input of the third FM demodulator 12 is connected to an output of the superposition stage SS, while an output is connected to the loop amplifier 6. In this third FM demodulator 12 the third IF signal is demodulated so that, likewise as with the first FM demodulator DEM, the higher-order interference components produced during demodulation are comparatively far remote from the desired baseband modulation signal and can be suppressed by means of a simple integrable low-pass filter.

It is further possible to implement the limiter 4 and the second FM demodulator in single phase by utilizing, for example, only the in-phase or the quadrature component of the second IF signal selected by the resonance amplifiers 1-3. In such an application it is possible to utilize the inventive idea - filtering at a relatively low frequency and demodulation at a relatively high frequency - in a wider sense, for example, as is shown by means of the FM demodulators in Figs. 3 and 4. These may be used instead of the limiter 4 and the second FM demodulator 5.

Fig. 3 shows a first embodiment of an FM demodulator for use in an FM receiver according to the invention, comprising a limiter 4' to which, for example the in-phase component of the second IF signal selected by the resonance amplifiers 1-3 is applied. The limiter 4' is connected *via* a fourth mixer stage M4 to a first input and *via* a filter circuit PS operating as a frequency-dependent phase shifter, followed by a fifth mixer stage M5, to a second input of a multiplier circuit M, said fourth and fifth mixer stages M4 and M5 receiving mutually equal mixing signals for an up-conversion of the frequency of the two input signals of the multiplier circuit M. The two mixing signals for the fourth mixer stage M4 and the fifth mixer stage M5 are supplied from the fixed oscillator FO and have a frequency which is, for example equal to 11 MHz. In contrast to the original second FM demodulator 5, a frequency demodulation at f3, *i.e.* a much higher frequency than f2 is effected in the multiplier circuit M in Fig. 3.

Fig. 4 shows a second embodiment of an FM demodulator for use in an FM receiver according to the invention, using a sixth mixer stage M6 to which, for example, the in-phase component of the second IF signal selected by the resonance amplifiers 1-3 is applied and which precedes the limiter circuit 4'. An 11 MHz mixing signal is applied to the sixth mixer stage M6 from the local oscillator device LO for an up-conversion of the frequency of the signal applied to the limiter, so that higher-order interference components can be suppressed with a simple filter downstream of the multiplier circuit M. The filter circuit PS arranged between the limiter circuit 4' and one of the two inputs of the multiplier circuit M is arranged between a seventh and an eighth mixer stage M7 and M8 for a down-conversion and an up-conversion of the frequency of the input signal and the output signal, respectively, of the filter circuit. Said 11 MHz mixing signal is applied also from the local oscillator device LO to the seventh mixer stage M7 and the eighth mixer stage M8. Consequently, filtering takes place at the comparatively low frequency f2, while demodulation takes place at the comparatively high frequency f3.

It will be evident that the invention is not limited to the embodiment shown in Fig. 1. For example, it is possible to use the inventive idea for a single or multistage and/or single-phase bandpass filter for selection in the second IF section with filter types other than resonance amplifiers, to arrange the loop filter 7 in the signal direction in the tuning control loop for the loop amplifier 6 or to omit it completely and/or even completely refrain from the dynamic frequency tracking of the resonance amplifiers 1-3. In the latter case the bandwidth should be chosen to be sufficiently large to comprise the bandwidth of the second IF signal. It is also possible to omit the third IF section IF3 and/or to render the FM demodulators shown in Figs. 3 and 4 suitable, after some adaptation, for use as the said first, second and/or third FM demodulator, DEM, 5 and 12, respectively. If less stringent requirements are imposed on the exchangeability of the second IF stage IFS, the output signal of the first FM demodulator may be used to vary the tuning of the bandpass filter in the second IF stage IFS *via* a suitably chosen amplification.

## Claims

1. An FM receiver comprising an RF section (RF,RFF), a first mixer stage (M1) for converting a desired RF reception signal to a first IF signal having a carrier frequency located on average at a first intermediate frequency, a first IF section (IF1) for selecting the first IF signal, a second mixer stage (M2) for converting the first IF signal to a second IF signal having a carrier frequency located on average at a second intermediate frequency, said second intermediate frequency being located below the first intermediate frequency, a second IF section (IF2) for selecting the second IF signal, a third mixer stage (M3) for converting the second IF signal to a third IF signal having a carrier frequency located on average at a third intermediate frequency, said third intermediate frequency being located above the second intermediate frequency, characterized in that the third intermediate frequency is equal to the first intermediate frequency and mutually equal second and third mixing signals are applied to the second (M2) and third (M3) mixer stages, and in that the FM receiver further comprises an FM demodulator (DEM) for demodulating the baseband modulation signal of said desired RF reception signal, and a low-pass filter coupled to an output of the FM demodulator (DEM) for selecting the baseband modulation signal, an input of said FM demodulator (DEM) being coupled *via* the third mixer stage (M3) to the second IF section (IF2).

2. An FM receiver as claimed in Claim 1, characterized by a phase-splitting device for converting a single-phase signal into a pair of phase-quadrature signals and a resonance amplifier (1) operating as a tunable phase-quadrature IF selectivity, which resonance amplifier (1) applies in-phase (I) and quadrature (Q) components of the second IF signal from in-phase and quadrature outputs to said third mixer stage (M3), said third mixer stage (M3) comprising in-phase (M3i) and quadrature (M3q) multiplier circuits as well as a superposition stage (SS) for converting the in-phase (I) and quadrature (Q) components of the second IF signal to in-phase and quadrature components of the third IF signal and for mutually superpositioning the two last-mentioned in-phase and quadrature components for converting the third intermediate frequency from phase quadrature to single phase.

3. An FM receiver as claimed in Claim 2, characterized in that the resonance amplifier (1) also operates as a phase-splitting device and has in-phase and quadrature inputs which are mutually coupled in common to an output of the second mixer stage (M2).

4. An FM receiver as claimed in Claim 2, characterized in that the second mixer stage (M2) also operates as a phase-splitting device and comprises in-phase (M2i) and quadrature (M2q) multiplier circuits, signal inputs of which are coupled in common to an output of the first IF section whose mixing signal inputs are coupled to in-phase and quadrature outputs of a fixed local phase-quadrature oscillator (LO) and signal outputs of which are coupled to in-phase and quadrature inputs of the resonance amplifier (1), said in-phase and quadrature outputs of the fixed local phase-quadrature oscillator (LO) being also coupled to respective mixing signal inputs of the in-phase (M3i) and quadrature (M3q) multiplier circuits of the third mixer stage (M3).

5. An FM receiver as claimed in any one of Claims 1 to 4, characterized in that the second IF section (IF2) comprises a tunable IF selectivity (1,2,3) having a tuning control input (9,10,11) to which the baseband modulation signal of said desired RF reception signal is applied for a dynamic frequency tracking of the tuning of the tunable IF selectivity by means of the modulation signal.

6. An FM receiver as claimed in Claim 5, characterized in that the tunable IF selectivity (1,2,3) in the second IF section (IF2) precedes a further FM demodulator (5) which is arranged in a tuning control loop from the output of the tunable IF selectivity (1,2,3) to the tuning control input (9,10,11), said tuning control loop having an open loop gain which is smaller than one.

7. An FM receiver as claimed in Claim 6, characterized in that the further FM demodulator (5) comprises a limiter circuit (4') which is connected *via* a fourth mixer stage (M4) to a first input and *via* a filter circuit (PS), succeeded by a fifth mixer stage (M5), to a second input of a multiplier circuit (M), mutually equal mixing signals being applied to said fourth (M4) and fifth (M5) mixer stages for an up-conversion of the frequency of the two input signals of the multiplier circuit (M).

8. An FM receiver as claimed in Claim 6, characterized in that the further FM demodulator (5) comprises a limiter circuit (4') which is connected to a first input and, *via* a filter circuit (PS), to a second input of a multiplier circuit (M), and a sixth mixer stage (M6) preceding the limiter circuit (4') for an up-conversion of the frequency of the signal applied to the limiter circuit (4').

9. An FM receiver as claimed in Claim 6, characterized in that at least one of the first-mentioned (DEM) and further (5) FM demodulators comprises a limiter circuit (4'), a multiplier circuit (M) having two inputs and an output and a filter circuit (PS) arranged between the limiter circuit (4') and one of the two inputs of the multiplier circuit (M), said filter circuit (PS) being arranged between a seventh (M7) and an eighth (M8) mixer stage for a down-conversion and an up-conversion, respectively, of the frequency of the input signal and the output signal of the filter circuit (PS).

10. An IF stage (IFS) comprising a second mixer stage (M2) for converting a first IF signal having a carrier frequency located on average at a first intermediate frequency to a second IF signal having a carrier frequency located on average at a second intermediate frequency, said second intermediate frequency being located below the first intermediate frequency, a second IF section (IF2) for selecting the second IF signal, a third mixer stage (M3) for converting the second IF signal to a third IF signal having a carrier frequency located on average at a third intermediate frequency, said third intermediate frequency being located above the second intermediate frequency, characterized in that the IF stage (IFS) further comprises an IF input terminal (IFI) to which the first IF signal can be supplied and an IF output terminal (IFO) from which the third IF signal can be tapped, and in that the third intermediate frequency is equal to the first intermediate frequency and mutually equal second and third mixing signals are applied to the second (M2) and third (M3) mixer stages from a common fixed oscillator.

11. An IF stage (IFS) as claimed in Claim 10, characterized in that the second IF section (IF2) comprises a tunable IF selectivity (1,2,3) having a tuning control input (9,10,11), said tunable IF selectivity (1,2,3) preceding a FM demodulator (5) which is arranged in a tuning control loop from the output of the tunable IF selectivity (1,2,3) to the tuning control input (9,10,11), said tuning control loop having an open loop gain which is smaller than one.

## Patentansprüche

1. FM-Empfänger mit einem HF-Teil (RF, RFF), einer ersten Mischstufe (M1) zur Umwandlung eines gewünschten HF-Empfangssignals in ein erstes ZF-Signal mit einer im Schnitt auf einer ersten Zwischenfrequenz liegenden Trägerfrequenz, mit einem ersten ZF-Teil (IF1) zur Selektion des ersten ZF-Signals, einer zweiten Mischstufe (M2) zur Umwandlung des ersten ZF-Signals zu einem zweiten ZF-Signal mit einer im Schnitt auf einer zweiten Zwischenfrequenz liegenden Trägerfrequenz, wobei diese zweite Zwischenfrequenz unterhalb der ersten Zwischenfrequenz liegt, mit einem zweiten ZF-Teil (IF2) zur Selektion des zweiten ZF-Signals, einer dritten Mischstufe (M3) zur Umwandlung des zweiten ZF-Signals zu einem dritten ZF-Signal mit einer Trägerfrequenz, die im Schnitt auf einer dritten Zwischenfrequenz liegt, wobei diese dritte Zwischenfrequenz über der zweiten Zwischenfrequenz liegt, dadurch gekennzeichnet, dass die dritte Zwischenfrequenz der ersten Zwischenfrequenz entspricht und dass der zweiten (M2) und dritten (M3) Mischstufe einander entsprechende zweite und dritte Mischsignale zugeführt werden, und dass der FM-Empfänger weiterhin einen FM-Demodulator (DEM) aufweist zum Demodulieren des Basisbandmodulationssignals des genannten gewünschten HF-Empfangssignals, und wobei ein Tiefpassfilter mit einem Ausgang des FM-Demodulators (DEM) gekoppelt ist zum Selektieren des Basisbandmodulationssignals, wobei ein Eingang des genannten FM-Demodulators (DEM) über die dritte Mischstufe (M3) mit dem zweiten ZF-Teil (IF2) gekoppelt ist.

2. FM-Empfänger nach Anspruch 1, gekennzeichnet durch eine eine Phasenspaltanordnung zur Umwandlung eines Einphasensignals in ein Paar Phasenquadratursignale und durch einen als abstimmbare Phasenquadratur-ZF-Selektivität wirksamen Resonanzverstärker (1), der an phasengleichen und an Quadraturausgängen der genannten dritten Mischstufe (M3) phasengleiche (I) bzw. Quadraturanteile (Q) des zweiten ZF-Signals liefert, wobei diese dritte Mischstufe (M3) phasengleiche (M3i) und Quadraturmultiplizierschaltungen (M3q) sowie eine Überlagerungsstufe (SS) umfasst, zwecks einer Umwandlung der phasengleichen (I) und Quadraturanteile (Q) des zweiten ZF-Signals in phasengleiche bzw. Quadraturanteile des dritten ZF-Signals und zwecks einer gegenseitigen Überlagerung der beiden letztgenannten phasengleichen und Quadraturanteile zur Umwandlung des dritten ZF-Signals von Phasenquadratur zu einphasig.

3. FM-Empfänger nach Anspruch 2, dadurch gekennzeichnet, dass der Resonanzverstärker (1) ebenfalls als Phasenspaltanordnung wirksam ist und phasengleiche und Quadratureingänge hat, die gegenseitig gemeinsam mit einem Ausgang der zweiten Mischstufe (M2) gekoppelt sind.

4. FM-Empfänger nach Anspruch 2, dadurch gekennzeichnet, dass die zweite Mischstufe (M2) ebenfalls als Phasenspaltanordnung wirksam ist und phasengleiche (M2i) und Quadraturmultiplizierschaltungen (M2q) aufweist, wobei Eingänge derselben gemeinsam mit einem Ausgang des ersten ZF-Teils gekoppelt sind, wobei die Mischsignaleingänge mit phasengleichen und Quadraturausgängen eines festen örtlichen Phasenquadraturoszillators (LO) gekoppelt sind und Signalausgänge desselben mit phasengleichen und Quadratureingängen des Resonanzverstärkers (1) gekoppelt sind, wobei die genannten phasengleichen und Quadraturausgänge des festen örtlichen Phasenquadraturoszillators (LO) ebenfalls mit betreffenden Mischsignaleingängen der phasengleichen (M3i) und der Quadraturmultiplizierschaltungen (M3q) der dritten Mischstufe (M3) gekoppelt sind.

5. FM-Empfänger nach einem der Ansprüche 1 bis 4, dadurch gekennzeichnet, dass der zweite ZF-Teil (IF2) eine abstimmbare ZF-Selektivität (1,2,3) aufweist mit einem Abstimmregeleingang (9,10,11), dem das Basisbandmodulationssignal des gewünschten HF-Empfangssignals zur dynamischen Frequenzfolge der Abstimmung der abstimmbaren ZF-Selektivität mittels des Modulationssignals zugeführt wird.

6. FM-Empfänger nach Anspruch 5, dadurch gekennzeichnet, dass die abstimmbare ZF-Selektivität (1,2,3) in dem zweiten ZF-Teil (IF2) einem weiteren FM-Demodulator (5) vorgeschaltet ist, der in einer Abstimmschleife von dem Ausgang der abstimmbaren ZF-Selektivität (1,2,3) zu dem Abstimmregeleingang (9,10,11) vorgesehen ist, wobei diese Abstimmschleife eine offene Schleifenverstärkung aufweist, die kleiner ist als eins.

7. FM-Empfänger nach Anspruch 6, dadurch gekennzeichnet, dass der weitere FM-Demodulator (5) eine Begrenzerschaltung (4') aufweist, die über eine vierte Mischstufe (M4) mit einem ersten Eingang und über eine Filterstufe (PS) und eine nachfolgende fünfte Mischstufe (M5), mit einem zweiten Eingang einer Multiplizierschaltung (M) verbunden ist, wobei der genannten vierten (M4) und fünften (M5) Mischstufe zwecks einer Aufwärtsmischung der Frequenz der beiden Eingangssignale der Multiplizierschaltung (M) untereinander gleiche Mischsignale zugeführt werden.

8. FM-Empfänger nach Anspruch 6, dadurch gekennzeichnet, dass der weitere FM-Demodulator (5) mit einer Begrenzerschaltung (4'), die an einem ersten Eingang und über eine Filterschaltung (PS) an einem zweiten Eingang einer Multiplizierschaltung (M) liegt, sowie mit einer sechsten Mischstufe (M6) versehen ist, die vor der Begrenzerschaltung (4') liegt, dies zwecks einer Aufwärtsmischung der Frequenz des dem Begrenzer (4') zugeführten Signals.

9. FM-Empfänger nach Anspruch 6, dadurch gekennzeichnet, dass wenigstens einer der erstgenannten (DEM) und weiteren (5) FM-Demodulatoren mit einer Begrenzerschaltung (4' ), mit einer Multiplizierschaltung (M) mit zwei Eingängen und einem Ausgang, sowie mit einer zwischen der weiteren Begrenzerschaltung (4' ) und einem der beiden Eingänge der Multiplizierschaltung (M) vorgesehenen Filterschaltung (PS) versehen ist, wobei diese Filterschaltung (PS) zwischen einer siebenten (M7) und einer achten Mischstufe (M8) für eine Abwärts- bzw. Aufwärtsmischung der Frequenz des Eingangs- und Ausgangssignals der Filterschaltung (PS) vorgesehen ist.

10. ZF-Stufe (IFS), die eine zweite Mischstufe (M2) aufweist, zur Umwandlung eines ersten ZF-Signals mit einer Trägerfrequenz im Schnitt auf einer ersten Zwischenfrequenz zu einem zweiten ZF-Signal mit einer Trägerfrequenz im Schnitt auf einer zweiten Zwischenfrequenz, wobei diese zweite Zwischenfrequenz unterhalb der ersten Zwischenfrequenz liegt, und die einen zweiten ZF-Teil (IF2) zum Selektieren des zweiten ZF-Signals, eine dritte Mischstufe (M3) zur Umwandlung des zweiten ZF-Signals zu einem dritten ZF-Signal mit einer Trägerfrequenz im Schnitt auf einer dritten Zwischenfrequenz aufweist, wobei diese genannte dritte Zwischenfrequenz über der zweiten Zwischenfrequenz liegt, dadurch gekennzeichnet, dass die ZF-Stufe (IFS) weiterhin eine ZF-Eingangsklemme (IFI) hat, der das erste ZF-Signal zugeführt werden kann und eine ZF-Ausgangsklemme (IFO), der das dritte ZF-Signal entnommen werden kann, und dass die dritte Zwischenfrequenz der ersten Zwischenfrequenz entspricht und dass der zweiten (M2) und dritten (M3) Mischstufe einander entsprechende zweite und dritte Mischsignale von einem gemeinsamen festen Oszillator aus zugeführt werden.

11. ZF-Stufe (IFS) nach Anspruch 10, dadurch gekennzeichnet, dass der zweite ZF-Teil (IF2) eine abstimmbare IF-Selektivität (1,2,3) aufweist mit einem Abstimmregeleingang (9,10,11), wobei die genannte abstimmbare ZF-Selektivität (1,2,3) einem FM-Demodulator (5) vorgeschaltet ist, der in einer Abstimmregelschleife von dem Ausgang der abstimmbaren ZF-Selektivität (1,2,3) zu dem Abstimmregeleingang (9,10,11) vorgesehen ist, wobei diese Abstimmregelschleife eine offene Schleifenverstärkung hat, die kleiner ist als eins.

## Revendications

1. Récepteur FM comportant une partie RF (RF, RFF), un premier étage mélangeur (M1) pour convertir un signal de réception RF souhaité en un premier signal IF présentant une fréquence porteuse située en moyenne à une première fréquence intermédiaire, une première partie IF (IF1) pour sélectionner le premier signal IF, un deuxième étage mélangeur (M2) pour convertir le premier signal IF en un deuxième signal IF présentant une fréquence porteuse située en moyenne à une deuxième fréquence intermédiaire, ladite deuxième fréquence intermédiaire étant située au-dessous de la première fréquence intermédiaire, une deuxième partie IF (IF2) pour sélectionner le deuxième signal IF, un troisième étage mélangeur (M3) pour convertir le deuxième signal IF en un troisième signal IF présentant une fréquence porteuse située en moyenne à une troisième fréquence intermédiaire, ladite troisième fréquence intermédiaire étant située au-dessus de la deuxième fréquence intermédiaire, caractérisé en ce que la troisième fréquence intermédiaire est égale à la première fréquence intermédiaire et des deuxième et troisième signaux mélangeurs mutuellement égaux sont appliqués aux deuxième (M2) et troisième étages mélangeurs (M3), et en ce que le récepteur FM comporte encore un démodulateur FM (DEM) pour démoduler le signal de modulation en bande de base dudit signal de réception RF souhaité et un filtre passe-bas couplé à une sortie du démodulateur FM (DEM) pour sélectionner le signal de modulation en bande de base, une entrée dudit démodulateur FM (DEM) étant couplée par l'intermédiaire du troisième étage mélangeur (M3) à la deuxième partie IF (IF2).

2. Récepteur FM selon la revendication 1, caractérisé par un dispositif diviseur de phase pour convertir un signal monophasé en une paire de signaux en quadrature de phase et un amplificateur de résonance (1) fonctionnant comme sélectivité IF en quadrature de phase accordable, ledit amplificateur de résonance (1) appliquant des composantes en phase (I) et en quadrature (Q) du deuxième signal IF à partir de sorties en phase et en quadrature audit troisième étage mélangeur (M3), ledit troisième étage mélangeur (M3) comportant des circuits multiplicateurs en phase (M3i) et en quadrature (M3q) aussi bien qu'un étage de superposition (SS) pour convertir les composantes en phase (I) et en quadrature (Q) du deuxième signal IF en des composantes en phase et en quadrature du troisième signal IF et pour superposer mutuellement les deux dernières composantes en phase et en quadrature pour convertir la troisième fréquence intermédiaire de quadrature de phase en monophase.

3. Récepteur FM selon la revendication 2, caractérisé en ce que l'amplificateur de résonance (1) fonctionne également comme dispostif diviseur de phase et présente des entrées en phase et en quadrature qui sont mutuellement couplées en commun à une sortie du deuxième étage mélangeur (M2).

4. Récepteur FM selon la revendication 2, caractérisé en ce que le deuxième étage mélangeur (M2) fonctionne également comme dispositif diviseur de phase et comporte des circuits multiplicateurs en phase (M2i) et en quadrature (M2q) dont les entrées de signal sont couplées en commun à une sortie de la première partie IF dont des entrées de signal de mélange sont couplées à des sorties en phase et en quadrature d'un oscillateur en quadrature de phase local fixe (LO) et dont des sorties de signal sont couplées à des entrées en phase et en quadrature de l'amplificateur de résonance (1), lesdites sorties en phase et en quadrature de l'oscillateur en quadrature de phase local fixe (LO) étant également couplées à de propres entrées de signal de mélange des circuits multiplicateurs en phase (M3i) et en quadrature (M3q) du troisième étage mélangeur (M3).

5. Récepteur FM selon l'une quelconque des revendications précédentes 1 à 4, caractérisé en ce que la deuxième partie IF (IF2) comporte une sélectivité IF accordable (1, 2, 3) présentant une entrée de commande d'accord (9, 10, 11) à laquelle est appliqué le signal de modulation en bande de base dudit signal de réception RF souhaité pour une poursuite en fréquence dynamique de l'accord de la sélectivité IF accordable à l'aide du signal de modulation.

6. Récepteur FM selon la revendication 5, caractérisé en ce que la sélectivité IF accordable (1, 2, 3) dans la deuxième partie IF (IF2) précède un nouveau autre démodulateur FM (5) qui est disposé dans une boucle de commande d'accord s'étendant à partir de la sortie de la sélectivité IF accordable (1, 2, 3) vers l'entrée de commande d'accord (9, 10,11), ladite boucle de commande d'accord présentant un gain de boucle ouverte qui est inférieur à un.

7. Récepteur FM selon la revendication 6, caractérisé en ce que le nouveau autre démodulateur FM (5) comporte un circuit limiteur (4') qui est relié par l'intermédiaire d'un quatrième étage mélangeur (M4) à une première entrée et par l'intermédiaire d'un circuit de filtrage (PS), suivi d'un cinquième étage mélangeur (M5), à une deuxième entrée d'un circuit multiplicateur (M), des signaux mélangeurs mutuellement égaux étant appliqués auxdits quatrième (M4) et cinquième étages mélangeurs (M5) pour une conversion élévatrice de la fréquence des deux signaux d'entrée du circuit multiplicateur (M).

8. Récepteur FM selon la revendication 6, caractérisé en ce que le nouveau autre démodulateur FM (5) comporte un circuit limiteur (4') qui est relié à une première entrée et, par l'intermédiaire d'un circuit de filtrage (PS), à une deuxième entrée d'un circuit multiplicateur (M), et un sixième étage mélangeur (M6) précédant le circuit limiteur (4') pour une conversion élévatrice de la fréquence du signal appliqué au circuit limiteur (4').

9. Récepteur FM selon la revendication 6, caractérisé en ce qu'au moins un des démodulateurs FM premiers nommés (DEM) et des nouveaux autres démodulateurs FM (5) comporte un circuit limiteur (4'), un circuit multiplicateur (M) présentant deux entrées et une sortie et un circuit de filtrage (PS) disposé entre le circuit limiteur (4') et l'une des deux entrées du circuit multiplicateur (M), ledit circuit de filtrage (PS) étant disposé entre un septième (M7) et un huitième étage mélangeur (M8) pour une conversion d'abaissement respectivement élévatrice de la fréquence du signal d'entrée et du signal de sortie du circuit de filtrage (PS).

10. Etage IF (IFS) comportant un deuxième étage mélangeur (M2) pour convertir un premier signal IF présentant une fréquence porteuse située en moyenne à une première fréquence intermédiaire en un deuxième signal IF présentant une fréquence porteuse située en moyenne à une deuxième fréquence intermédiaire, ladite deuxième fréquence intermédiaire étant située au-dessous de la première fréquence intermédiaire, une deuxième partie IF (IF2) pour sélectionner le deuxième signal IF, un troisième étage mélangeur (M3) pour convertir le deuxième signal IF en un troisième signal IF présentant une fréquence porteuse située en moyenne à une troisième fréquence intermédiaire, ladite troisième fréquence intermédiaire étant située au-dessus de la deuxième fréquence intermédiaire, caractérisé en ce que l'étage IF (IFS) comporte encore une borne d'entrée IF (IFI) à laquelle peut être délivré le premier signal IF et une borne de sortie IF (IFO) de laquelle peut être pris le troisième signal IF, et en ce que la troisième fréquence intermédiaire est égale à la première fréquence intermédiaire et des deuxième et troisième signaux mélangeurs mutuellement égaux sont appliqués à partir d'un oscillateur fixe commun aux deuxième (M2) et troisième étages mélangeurs (M3).

11. Etage IF (IFS) selon la revendication 10, caractérisé en ce que la deuxième partie IF (IF2) comporte une sélectivité IF accordable (1, 2, 3) présentant une entrée de commande d'accord (9, 10, 11), ladite sélectivité IF accordable (1, 2, 3) précédant un démodulateur FM (5) qui est disposé dans une boucle de commande d'accord s'étendant à partir de la sortie de la sélectivité IF accordable (1, 2, 3) vers l'entrée de commande d'accord (9, 10, 11), ladite boucle de commande d'accord présentant un gain de boucle ouverte qui est inférieur à un.
